# EUROPEAN PATENT APPLICATION

(11) **EP 2 116 586 A1**
(43) Date of publication of application: **11.11.2009**
(21) Application number: 07851091.4
(22) Date of filing: 21.12.2007
(51) Int. Cl.: C09K 11/59, C09K 11/08, H01L 33/00

(54) **FLUORESCENT SUBSTANCE, PROCESS FOR PRODUCING THE SAME, WAVELENGTH CONVERTER, FLUORESCENT DEVICE, AND ILLUMINATOR**

(30) Priority: 25.12.2006 JP 2006348419; 25.01.2007 JP 2007014530; 26.03.2007 JP 2007078282; 29.08.2007 JP 2007222984
(71) Applicant: Kyocera Corporation, Kyoto-shi Kyoto 612-8501 (JP)
(72) Inventor: KATOU, Wataru, Kirishima-shi Kagoshima 899-4312 (JP); KOSHITANI, Naoki, Kirishima-shi Kagoshima 899-4312 (JP)
(74) Representative: HOFFMANN EITLE
(86) International application number: PCT/JP2007/074739
(87) International publication number: WO 2008/078711

(57) **Abstract**

A phosphor operable to absorb ultraviolet or visible light and emit visible light with longer wavelength and a process for producing same is disclosed. A wavelength converter phosphor material comprising Eu, Mg, Mn, and Si as essential components converts the wavelength of light emitted from a light-emitting element such as a light emitting diode (LED) into a changed wavelength for emission. An illumination device such as a luminaire may be equipped with the wavelength converter.

## Description

### TECHNICAL FIELD

The present invention relates to a phosphor capable of absorbing ultraviolet or visible light and emitting visible light with longer wavelength and a process for producing the same. The invention also relates to a wavelength converter including a phosphor capable of changing the wavelength of light emitted from a light-emitting element such as an LED (Light Emitting Diode) and emitting light with the changed wavelength to the outside. The invention also relates to a illumination device equipped with such a wavelength converter and to an luminaire having such a illumination device.

### BACKGROUND ART

Light-emitting elements (hereinafter also referred to as LED chips) including semiconductor materials are small and can emit bright colors with high power efficiency. LED chips are characterized by having long product life and low power consumption and being strong against repeated on/off switching and therefore are expected to be useful for light sources for lighting such as backlight sources for liquid crystal displays and phosphor lamps.

LED chips are used for a illumination device that has a phosphor to change the wavelength of light from the LED chips and emits a mixture of light with the changed wavelength and the light from the LED chips so that light of a color different from that of the light from the LED can be emitted.

A known example of such a illumination device includes a phosphor for a yellow light component, such as a YAG phosphor represented by the compositional formula (Y,Gd)₃(Al,Ga)₅O₁₂, which is placed on a blue LED chip.

In this illumination device, light emitted from the LED chip is applied to the phosphor for a yellow light component, so that the phosphor is excited to emit visible light, which is used for the output. However, when the brightness of the LED chip is changed, the amount ratio between the blue light and the yellow light is changed so that the tone of white color can be changed, which causes the problem of low color rendering properties.

In order to solve the problem, therefore, it is proposed that a violet LED chip having a peak at 400 nm or less should be used; a structure containing a mixture of three types of phosphors should be used in a wavelength converter; and violet light should be converted to red, green and blue wavelengths, respectively so that white light can be emitted (see Patent Document 1). This technique can improve the color rendering properties.

However, the phosphor capable of producing red light from exciting light at about 400 nm in the ultraviolet region has low quantum efficiency, and therefore, there has been a problem in which the luminous efficiency of white light cannot be improved.

Under the circumstances, red light-emitting phosphor have been developed, and in conventional techniques, red light-emitting silicate phosphor represented by the chemical formula Ba_{3-x-y}EuₓMnyMgSi₂O₈ are known (see Non-Patent Document 1).
[Patent Document 1] Japanese Unexamined Patent Application Publication No. 2002-314142
[Non-Patent Document 1] Journal of Electrochemical Society, 1968, pp773-778

### DISCLOSURE OF INVENTION

### PROBLEMS TO BE SOLVED BY THE INVENTION

However, there is a problem in the Non-Patent Document 1 in which the quantum efficiency of the silicate phosphor represented by the chemical formula Ba_{3-x-y}EuₓMn_{y}MgSi₂O₈ described in Non-Patent Document 1 is still low.

The inventors carried out tracing experiments on the silicate phosphor represented by the chemical formula Ba_{3-x-y}EuₓMn_{y}MgSi₂O₈ described in Non-Patent Document 1, and as a result, its quantum efficiency was still low. The inventors have made an investigation on the reason why the silicate phosphor represented by the chemical formula Ba_{3-x-y}EuₓMn_{y}MgSi₂O₈ described in Non-Patent Document 1 has low quantum efficiency.

As a result, it has been found that undesired (namely non-red-light-emitting) crystals (hetero-phase) can be easily precipitated, and the precipitation of such crystals not capable of emitting red light is difficult to control, so that the red quantum efficiency is low. Specifically, among the undesired crystals, Ba₂MgSi₂O₇, BaMgSiO₄ and Ba₂SiO₄ crystals emit green fluorescence other than red one, so that the mixture with light of color other than red reduces the red quantum efficiency.

An object of the invention is to provide a red fluorescence-emitting phosphor having high quantum efficiency, a process for producing the same, a wavelength converter, a illumination device, and an luminaire.

### MEANS FOR SOLVING THE PROBLEM

It has believed heretofore that Mn of an activator substitutes a part of Ba site in a silicate phosphor which contains Ba, Eu, Mn, Mg, and Si (which is represented by the compositional formula Ba_{3-x-y}EuₓMn_{y}MgSi₂O₈), and the substance was prepared such that it became such composition and heat-treated.

However, after a earnest study on the crystal (hetero-phase) which does not fit the original purpose, the inventors found that Mn does not substitute Ba site but Mg site in this phosphor by using EXAFS (Extended X-ray Absorption Fine Structure) measurement performed by the inventors.

Therefore, since it is non-stoichiometry with respect to a chemical formula of Ba_{3-x-y}EuₓMn_{y}MgSi₂O₈, Ba₂MgSi₂O₇, Ba₂SiO₄ and BaMgSiO₄ crystals, that is crystals which does not fit to the original purpose, deposit easily and these crystals can not be controlled as long as it is designed with the chemical formula of Ba_{3-x-y}EuₓMn_{y}MgSi₂O₈, and this resulted in the low quantum efficiency of the red light-emitting phosphors, and caused variation in quality, resulting in the present invention.

A phosphor according to the present invention comprises M¹, Eu, Mg, Mn, and Si as essential components, wherein M¹ represents Ba, a combination of Ba and Sr or a combination of Ba and Ca, the molar ratio of Eu to Si is 0.14 or less, and the molar ratio of Mn to Si is 0.07 or less; and an M¹₃MgSi₂O₈ crystal as a main crystal, wherein the M¹₃MgSi₂O₈ crystal contains Eu and Mn, and B/(A+B+C+D) is 0.1 or less, C/(A+B+C+D) is 0.1 or less, and D/(A+B+C+D) is 0.26 or less, wherein A represents the X-ray diffraction peak intensity of the M¹₃MgSi₂O₈ crystal detected at a 2θ angle of 31.5° to 33°, B represents the X-ray diffraction peak intensity of an M¹₂MgSi₂O₇ crystal detected at a 2θ angle of 27.7° to 29.2°, C represents the X-ray diffraction peak intensity of an M¹₂SiO₄ crystal detected at a 2θ angle of 29.2° to 30.8°, and D represents the X-ray diffraction peak intensity of an M¹MgSiO₄ crystal detected at a 2θ angle of 28.0° to 29.4°.

In addition, in the phosphor according to the present invention, D/(A+B+C+D) is 0.04 or more.

The phosphor according to the present invention has a chemical composition represented by M¹₃₋ₐEuₐMg_{1-b}Mn_{b}Si_{c}O₈, wherein a is a value satisfying 0<a≤0.264, b is a value satisfying 0<b≤0.132, and c is a value satisfying 1.905≤c≤2.025.

In the phosphor according to the present invention, M¹MgSiO₄ crystal grains exist in the M¹₃MgSi₂O₈ crystal grains.

A process for producing a phosphor according to the present invention, comprises heat-treating, in a reducing atmosphere, a material powder having a chemical composition represented by M¹₃₋ₐEuₐMg_{1-b}Mn_{b}Si_{c}O₈, wherein a is a value satisfying 0<a≤0.264, b is a value satisfying 0<b≤0.132, and c is a value satisfying 1.905≤c≤2.025.

A wavelength converter configured to change a wavelength of light emitted from a light source and outputting light containing light with the changed wavelength according to the present invention, comprises the above-mentioned phosphor dispersed in a transparent matrix. In other words, a wavelength converter configured to change a wavelength of light emitted from a light source and outputting light containing light with the chanced wavelength, comprises a transparent matrix and the above-mentioned phosphor dispersed in the transparent matrix

A illumination device according to the present invention, comprises: a base member comprising a mounting part configured to mount a light-emitting element on a surface thereof, and an electrical wiring; a light-emitting element that is placed on the mounting part and electrically connected to the electrical wiring; and the above-mentioned wavelength converter operable to change a wavelength of light emitted from the light-emitting element. In other words, a illumination device comprises: a light-emitting element; a base member comprising a mounting part mounting the light-emitting element; an electrical wiring on the surface of the base member electrically connected to the light-emitting element; the above-mentioned wavelength converter operable to change a wavelength of a part of light emitted from the light-emitting element to a light with a different wavelength.

An luminaire comprises a plurality of the illumination devices described above.

### EFFECTS OF THE INVENTION

The phosphor according to the present invention comprises M¹, Eu, Mg, Mn, and Si as essential components, wherein M¹ represents Ba, a combination of Ba and Sr or a combination of Ba and Ca, the molar ratio of Eu to Si is 0.14 or less, and the molar ratio of Mn to Si is 0.07 or less; and an M¹₃MgSi₂O₈ crystal as a main crystal, wherein the M¹₃MgSi₂O₈ crystal contains Eu and Mn, and B/ (A+B+C+D) is 0.1 or less, C/(A+B+C+D) is 0.1 or less, and D/(A+B+C+D) is 0.26 or less, wherein A represents the X-ray diffraction peak intensity of the M¹₃MgSi₂O₈ crystal detected at a 2θ angle of 31.5° to 33°, B represents the X-ray diffraction peak intensity of an M¹₂MgSi₂O₇ crystal detected at a 2θ angle of 27.7° to 29.2°, C represents the X-ray diffraction peak intensity of an M¹₂SiO₄ crystal detected at a 2θ angle of 29.2° to 30.8°, and D represents the X-ray diffraction peak intensity of an M¹MgSiO₄ crystal detected at a 2θ angle of 28.0° to 29.4°.

Therefore, the precipitation of M¹₂MgSi₂O₇, M¹₂SiO₄ and M¹MgSiO₄ crystals are suppressed so that the generation of green light other than red one can be suppressed, which can increase the red quantum efficiency.

In the phosphor of the invention, D/(A+B+C+D) may be set to 0.04 or more. In other words, besides the main M¹₃MgSi₂O₈ crystal, the M¹MgSiO₄ crystal may be precipitated in a given amount or more so that the red quantum efficiency can be higher than in the case that almost no M¹MgSiO₄ crystal is precipitated. It is not clear why the red quantum efficiency can be higher in such a case than in the case that almost no M¹MgSiO₄ crystal is precipitated. The inventors consider that in the presence of a given amount of the M¹MgSiO₄ crystal, the energy of light absorbed into M¹MgSiO₄ can be transferred to the M¹₃MgSi₂O₈ crystal so that the red quantum efficiency can be improved.

The phosphor of the invention may also have a chemical composition represented by M¹₃₋ₐEuₐMg_{1-b}Mn_{b}Si_{c}O₈, wherein a is a value satisfying 0≤a≤0.264, b is a value satisfying 0<b≤0.132, and c is a value satisfying 1.905≤c≤2.025, so that the phosphor can have a composition close to the stoichiometric composition and therefore reproducibly form the desired crystal.

The phosphor of the invention may also be characterized in that M¹MgSiO₄ crystal grains exist in the M¹₃MgSi₂O₈ crystal grains. The inventors consider that in such a structure, the energy of light absorbed into M¹MgSiO₄ can be sufficiently transferred to the main M¹₃MgSi₂O₈ crystal, so that the red quantum efficiency can be improved.

In the process for producing a phosphor of the invention, a material powder having a chemical composition represented by M¹₃₋ₐEuₐMg_{1-b}Mn_{b}Si_{c}O₈, wherein a is a value satisfying 0<a≤0.264, b is a value satisfying 0<b≤0.132, and c is a value satisfying 1.905≤c≤2.025, is heat-treated in a reducing atmosphere so that the phosphor can be produced. According to the process, therefore, the phosphor can have a composition close to the stoichiometric composition, and the precipitation of the desired crystal can be reproducibly controlled by modifying the composition. For example, B/(A+B+C+D), C/(A+B+C+D) and D/(A+B+C+D) can be easily controlled to be 0.1 or less, 0.1 or less and from 0.04 to 0.26, respectively.

The wavelength converter configured to change a wavelength of light emitted from a light source and outputting light containing light with the changed wavelength according to the present invention, comprises the above-mentioned phosphor dispersed in a transparent matrix. In other words, a wavelength converter configured to change a wavelength of light emitted from a light source and outputting light containing light with the chanced wavelength, comprises a transparent matrix and the above-mentioned phosphor dispersed in the transparent matrix.

Therefore wavelength converter provides improved red quantum efficiency and therefore can improve the luminous efficiency of white light when used in a illumination device.

The illumination device according to the present invention, comprises: a base member comprising a mounting part configured to mount a light-emitting element on a surface thereof, and an electrical wiring; a light-emitting element that is placed on the mounting part and electrically connected to the electrical wiring; and the above-mentioned wavelength converter operable to change a wavelength of light emitted from the light-emitting element.The illumination device of the invention provides improved luminous efficiency of white light.

The luminaire including a plurality of the illumination devices provides improved color rendering properties.

### BEST MODE FOR CARRYING OUT THE INVENTION

The phosphor of this embodiment contains M¹, Eu, Mg, Mn, and Si as essential components, wherein M¹ represents Ba, a combination of Ba and Sr or a combination of Ba and Ca. The molar ratio of Eu to Si is 0.14/1 or less, and the molar ratio of Mn to Si is 0.07/1 or less.

The phosphor of this embodiment typically has a chemical composition of M¹₃₋ₐEuₐMg_{1-b}Mn_{b}Si_{c}O₈, wherein a is a value satisfying 0<a≤0.264, b is a value satisfying 0<b≤0.132, and c is a value satisfying 1.905≤c≤2.025. The phosphor represented by this chemical composition formula has a composition close to the stoichiometric one and can reproducibly form crystals capable of converting exciting light into red light, make it possible to readily control the crystal phase, and make it possible to suppress conversion into light of any color other than red.

The molar ratio a of Eu in M¹₃₋ₐEuₐMg_{1-b}Mn_{b}Si_{c}O₈ only has to satisfy 0<a≤0.264. If the molar ratio a of the emission center ion Eu²⁺ is too low, however, the quantum efficiency may tend to be low. On the other hand, if the molar ratio a is too high, the quantum efficiency may also tend to be low due to a phenomenon called concentration quenching. The molar ratio a preferably has a lower limit of 0.06 (0.06≤a) and in particular, is preferably in the range of 0.1 to 0.2 (0.1≤a≤0.2).

The molar ratio b of Mn only has to satisfy 0<b≤0.132. However, it is considered that in the phosphor of this embodiment, the energy of Eu²⁺ excited by exciting light irradiation should be transferred to Mn²⁺ so that Mn²⁺ can emit red light, and therefore, the degree of the energy transfer should vary with the Mn content. In order to obtain red high quantum efficiency, therefore, 0.01≤b≤0.1 should preferably be satisfied. The ratio b should more preferably satisfy 0.075≤b≤0.1.

The value c only has to satisfy 1.905≤c≤2.025.

The florescent substance may also be represented by the chemical composition formula: M¹_{3-x-y}EuₓMgMn_{y}Si_{z}O₈, wherein x is a value satisfying 0<x≤0.2, y is a value satisfying 0<y≤0.1, and z is a value satisfying 1.905≤z≤2.025.

An important feature of this embodiment is that the phosphor includes an M¹₃MgSi₂O₈ crystal as a main crystal, wherein the M¹₃MgSi₂O₈ crystal contains Eu and Mn, and B/(A+B+C+D) is 0.1 or less, C/(A+B+C+D) is 0.1 or less, and D/(A+B+C+D) is 0.26 or less, wherein A represents the X-ray diffraction peak intensity of the M¹₃MgSi₂O₈ crystal detected at a 2θ angle of 31.5° to 33°, B represents the X-ray diffraction peak intensity of an M¹₂MgSi₂O₇ crystal detected at a 2θ angle of 27.7° to 29.2°, C represents the X-ray diffraction peak intensity of an M¹₂SiO₄ crystal detected at a 2θ angle of 29.2° to 30.8°, and D represents the X-ray diffraction peak intensity of an M¹MgSiO₄ crystal detected at a 2θ angle of 28.0° to 29.4°.

The phosphor of this embodiment includes the Eu and Mn-containing M¹₃MgSi₂O₈ crystal as a main crystal, in which Eu and Mn each function as an activator to absorb exciting light and to emit light. In this embodiment, the main crystal should have an A/(A+B+C+D) value of more than 0.5, particularly more than 0.695, more preferably 0.74 or more.

The phosphor having a B/(A+B+C+D) value of 0.1 or less, a C/(A+B+C+D) value of 0.1 or less, and a D/(A+B+C+D) value of 0.26 or less as stated above can have high red quantum efficiency, because green emission from crystals other than the M¹₃MgSi₂O₈ crystal containing Eu and Mn as activators can be suppressed.

In contrast, when B/(A+B+C+D) or C/(A+B+C+D) is more than 0.1 or when D/(A+B+C+D) is more than 0.26, the red quantum efficiency becomes low. In particular, B/(A+B+C+D) is preferably 0.0709 or less, and C/(A+B+C+D) is preferably 0.0336 or less. It is preferred that the M¹₂MgSi₂O₇ or M¹₂SiO₄ crystal should be substantially absent or produced in a small amount.

Concerning the M¹MgSiO₄ crystal, 0.04≤D/(A+B+C+D)≤0.26 should be satisfied, so that the red quantum efficiency can be rather higher than that in the case of an M¹₃MgSi₂O₈ crystal alone or in the case of a D/(A+B+C+d) value of less than 0.04. Particularly in order to increase the red quantum efficiency, the D/(A+B+C+D) value is preferably from 0.08 to 0.25.

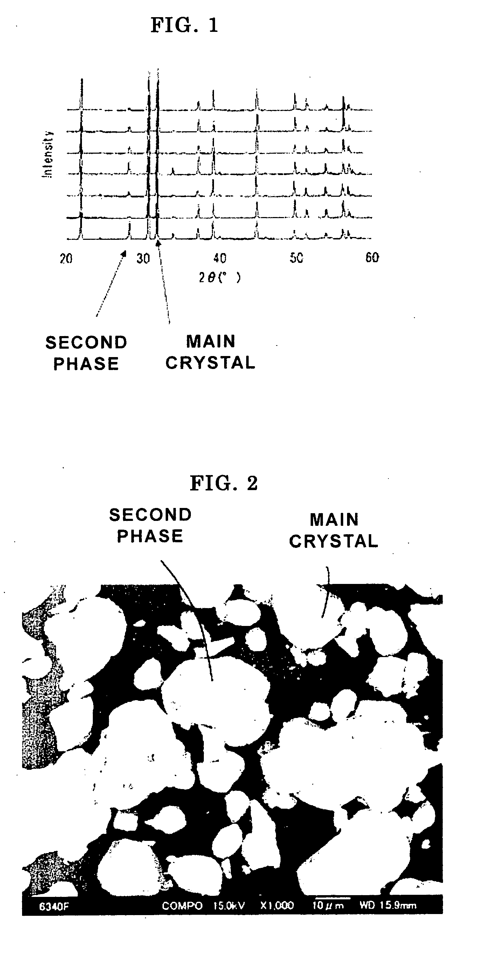

As shown in Fig. 1, the phosphor of this embodiment includes a Eu and Mn-containing M¹₃MgSi₂O₈ crystal as a main crystal and may further include an M¹MgSiO₄ crystal, which is produced as a second phase, and an M¹₂MgSi₂O₇ or M¹₂SiO₄ crystal, which is produced as a hetero-phase. As described above, however, it is preferred that the M¹₂MgSi₂O₇ or M¹₂SiO₄ crystal should be substantially absent or present in a small amount in the phosphor of this embodiment. Fig. 1 shows the result of the X-ray diffraction measurement of different phosphor powders having different M¹MgSiO₄ content.

As shown in Fig. 2, the phosphor of this embodiment includes M¹MgSiO₄ crystal grains present in M¹₃MgSi₂O₈ crystal grains. The inventors consider that such a structure allows sufficient energy transfer from light absorbing M¹MgSiO₄ to the M¹₃MgSi₂O₈ crystal so that the red quantum efficiency can be improved.

M¹ represents Ba, a combination of Ba and Sr or a combination of Ba and Ca. In particular, M¹ preferably represents Ba.

When M¹ represents Ba, the X-ray diffraction peak intensity of the Eu and Mn-containing M¹₃MgSi₂O₈ crystal detected at a 2θ angle of 31.5° to 32° may be represented by A, the X-ray diffraction peak intensity of an M¹₂MgSi₂O₇ crystal detected at a 2θ angle of 27.7° to 28.2° may be represented by B, the X-ray diffraction peak intensity of an M¹₂SiO₄ crystal detected at a 2θ angle of 29.2° to 29.8° may be represented by C, and the X-ray diffraction peak intensity of an M¹MgSiO₄ crystal detected at a 2θ angle of 28.0° to 28.4° may be represented by D.

When M¹ represents a combination of Ba and Sr or Ca, the respective peaks may slightly shift to the high angle side relative to the case that M¹ represents Ba, and therefore, the Eu and Mn-containing M¹₃MgSi₂O₈ crystal may be detected at a 2θ angle of 32.0° to 33°, the M¹₂MgSi₂O₇ crystal may be detected at a 2θ angle of 28.2° to 29.2°, the M¹₂SiO₄ crystal may be detected at a 2θ angle of 29.7° to 30.8°, and the M¹MgSiO₄ crystal may be detected at a 2θ angle of 28.7° to 29.4°.

The phosphor of this embodiment may be produced by a process that includes preparing a mixture of compounds as sources of the elements Ba, Sr, Ca, Mg, Eu, Mn, and Si and optionally a flux such as ammonium chloride, barium chloride or strontium chloride by the mixing method (A) or (B) described below, calcining the mixture, heat-treating the mixture in a reducing atmosphere, washing the mixture, drying the mixture, and sifting the mixture so that a phosphor composed of an aggregate of particles whose D₉₀ is 50 µm or less is produced. As used herein, the term "D₉₀" refers to a particle size at which the cumulative particle size distribution reaches 90%.
(A) A dry mixing method using a dry mill such as a hammer mill, a roll mill, a ball mill, or a jet mill.
(B) A wet mixing method that includes adding water or the like to the materials, mixing the materials in the form of a slurry or.solution in a mill, and drying the materials by spray drying, thermal drying, natural drying, or the like.

Of these mixing methods, the latter wet mixing method is particularly preferred, because a liquid medium should preferably be used in order to uniformly mix or disperse small amounts of activator element compounds over the whole and because the latter method can produce a uniform mixture of compounds of other elements.

The calcining process may include heating the mixture in a heat-resistant container such as a crucible or tray made of alumina or quartz under an atmosphere of a single type of gas such as oxygen or nitrogen or an atmosphere of a mixture thereof.

The heat-treating process may include heating the mixture in a heat-resistant container such as a crucible or tray made of alumina or quartz at 1000°C to 1300°C under an atmosphere of a mixture of oxygen, hydrogen and nitrogen for 1 to 24 hours.

Embedded calcining or microwave calcining may also be performed in order to suppress vaporization of component substances during the heat-treating process.

In order to satisfy 0.04≤D/(A+B+C+D)≤0.26, the composition of the phosphor may be controlled, or otherwise, the conditions for processing the mixture, such as the calcining temperature, the calcining time, the heat-treating temperature in the reducing atmosphere, or the heat-treating time may be changed so that 0.04≤D/(A+B+C+D)≤0.26 can be satisfied even with the same composition.

A combination of the calcining temperature and the reducing heat-treatment temperature may be as follows: 950°C≤calcining temperature≤1250°C and 1150°C≤reducing heat-treatment temperature≤1250°C. The calcining temperature holding time is preferably from 1 to 6 hours, and the reducing heat-treatment holding temperature is preferably from 1 to 12 hours. If a combination of the calcining temperature and the reducing heat-treatment temperature is too high, the second phase BaMgSiO₄ crystal may be precipitated in a large amount so that green light may be emitted to reduce the red quantum efficiency. If the calcining temperature is too low, the amount of the precipitated second phase BaMgSiO₄ crystal may be so small that energy transfer may be small and the quantum efficiency-increasing effect may be low.

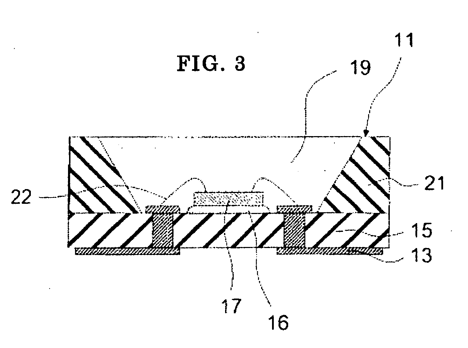

Next, a description is given of the wavelength converter of this embodiment and a illumination device equipped with the wavelength converter with reference to the drawings. Fig. 3 is a schematic cross-sectional view showing an example of the illumination device 11 of this embodiment. Referring to Fig. 3, the illumination device 11 of this embodiment includes a substrate (base component) 15 provided with electrodes 13, a light-emitting element 17 placed on the substrate 15, a monolayer wavelength converter 19 that is formed on the substrate 15 to cover the light-emitting element 17, and a reflective component 21 for reflecting light. In the drawing, reference numeral 22 represents wires, and reference numeral 16 an adhesive.

For example, the wavelength converter 19 has a transparent matrix containing a phosphor (not shown) to emit fluorescence at a wavelength of 430 nm to 490 nm (blue), a phosphor (not shown) to emit fluorescence at a wavelength of 520 nm to 570 nm (green), and a phosphor to emit fluorescence at a wavelength of 600 nm to 650 nm (red). When the light-emitting element 17 serving as a light source emits light, the wavelength converter 19 converts part of the wavelengths of the emitted light to another wavelength and outputs light containing the wavelength component resulting from the conversion, so that the light from the light-emitting element 17 containing a certain wavelength component is converted to light containing a different wavelength component.

The blue-emitting phosphor typically includes a material capable of being excited by light with a wavelength of about 400 nm at high quantum efficiency. The green-emitting phosphor typically includes a material capable of being excited by light with a wavelength of 400 nm to 460 nm. The red-emitting phosphor typically includes a material capable of being excited not only by light with a wavelength of 400 nm to 460 nm but also by light with a wavelength of about 550 nm.

According to this structure, the wavelength converter 19 of this embodiment and the illumination device 11 of this embodiment can be readily manufactured using the phosphor of this embodiment.

In the wavelength converter 19, the phosphors can be uniformly dispersed and supported and prevented from photodegradation. When the wavelength converter 19 is formed, therefore, the phosphors are preferably dispersed in a transparent matrix such as a polymer resin or a glass material. A polymer resin film or a glass material such as a sol-gel glass thin film preferably has high transparency and durability such that discoloration would not easily occur due to heat or light.

Examples of materials that may be used to form the polymer resin film include, but are not limited to, epoxy resins, silicone resins, polyethylene terephthalate, polybutylene terephthalate, polyethylene naphthalate, polystyrene, polycarbonate, polyether sulfone, cellulose acetate, polyarylate, and derivatives thereof. In particular, the polymer resin film preferably has high transparency in the wavelength range of 350 nm or more. Silicone resins are more preferably used in view of heat resistance in addition to such transparency.

Examples of glass materials may include silica, titania, zirconia, and composite materials thereof. The phosphors may be each independently dispersed in a glass material. The glass material can prolong the life of the product, because it is highly resistant to light, particularly ultraviolet light, and to heat, as compared with the polymer resin film. The glass material can also form a reliable illumination device, because it can improve the stability.

The wavelength converter 19 may be formed by a coating method using a glass material such as a sol-gel glass film or a polymer resin film. The coating method is preferably dispenser coating, while it may be any general coating method. For example, the wavelength converter 19 may be produced by mixing the phosphor into a fluid uncured resin or glass material or a resin or glass material that is made plastic with a solvent. For example, a silicone resin may be used as the uncured resin. The resin may be of a two-component curing type or one-component curing type. When the resin is of a two-component curing type, the phosphor may be mixed into both or one of the components. An acrylic resin may be used as the resin capable of being made plastic with a solvent.

The uncured material may be formed into a film by dispenser coating or the like or poured into a specific mold and then fixed so that a cured wavelength converter 19 can be obtained. The method for curing the resin or glass material may be a curing method using thermal energy or light energy or a method for evaporating the solvent.

The conductor that forms the electrode 13 functions as an electrically conducting path to electrically connect the light-emitting element 17. The conductor is drawn from the lower face of the substrate 15 to the upper face and electrically connected to the light-emitting element 17 through the wire 22. For example, a metalized layer containing particles of a metal such as W, Mo, Cu, or Ag may be used as the conductor. When the substrate 15 is ceramic, the wiring conductor may be formed on the upper face of it by heat-treating, at high temperature, a metal paste including tungsten (W) or molybdenum (Mo)-manganese (Mn) or the like. When the substrate 15 is made of resin, a lead terminal made of copper (Cu) or an iron (Fe)-nickel (Ni) alloy or the like may be placed and fixed into the substrate 15 by molding.

The substrate 15 is required to have high thermal conductivity and high total reflectivity. For example, therefore, a ceramic material such as aluminum nitride or a dispersion of metal oxide fine particles in a polymer resin is preferably used for the substrate 15.

The phosphor can be efficiently excited using the light-emitting element 17. Therefore, the light-emitting element used may include a semiconductor material capable of emitting light at a center wavelength of 370 to 420 nm so that a illumination device having high light power intensity and higher luminous efficiency can be provided.

The light-emitting element 17, which preferably emit light at the above center wavelength, preferably has a structure (not shown) including a light-emitting layer made of a semiconductor material, in order to have high external quantum efficiency. Examples of such a semiconductor material include various semiconductors such as ZnSe and nitride semiconductors such as GaN. The semiconductor material may be of any type, as long as it has an emission wavelength in the above wavelength range. The semiconductor material may be deposited by a crystal growth method such as a metal-organic chemical vapor-phase deposition (MOCVD) method or a molecular beam epitaxy method so that a laminated structure having a light-emitting layer made of the semiconductor material can be formed on a light-emitting element substrate. When a nitride semiconductor light-emitting layer is formed on the surface, for example, sapphire, spinel, SiC, Si, ZnO, ZrB₂, GaN, or quartz or the like is preferably used for the light-emitting element substrate, in order to form the nitride semiconductor with high crystallinity and high mass-productivity.

If necessary, a reflective component 21 for reflecting light may be formed on the side of the light-emitting element 17 and the wavelength converter 19 so that light escaping toward the side can be reflected to the front to increase the light power intensity. Examples of materials that may be used to form the reflective component 21 include aluminum (Al), nickel (Ni), silver (Ag), chromium (Cr), titanium (Ti), Copper (Cu), gold (Au), iron (Fe), laminated structures thereof or alloys thereof, ceramics such as alumina ceramics, and resins such as epoxy resins.

As shown in Fig. 3, the illumination device of this embodiment may be obtained by placing the wavelength converter 19 on the light-emitting element 17. The method for placing the wavelength converter 19 on the light-emitting element 17 may include the step of providing the wavelength converter 19 in the form of a cured sheet and placing the wavelength converter 19 on the light-emitting element 17 or the steps of depositing a liquid uncured material on the light-emitting element 17 and curing the material.

For example, the luminaire of this embodiment is formed by placing a plurality of illumination devices each as shown in Fig. 3 on a substrate and electrically connecting the illumination devices to one another. Alternatively, a plurality of light-emitting elements 17, wavelength converters 19 and reflective components 21 may be formed on the surface of the substrate 15 to form a plurality of illumination devices, which may be electrically connected to one another to form the luminaire.

The phosphor, wavelength converter, and illumination device of the invention are more specifically described by the examples and the comparative examples below. However, the examples below are not intended to limit the scope of the invention.

### Example 1

Powders of barium carbonate, magnesium oxide, strontium carbonate, calcium carbonate, silicon dioxide, europium oxide, manganese oxide, zinc acetate, and germanium dioxide were used. The powders were mixed in a plastic pot so that the molar ratio of each component element could be obtained as shown in Table 1. The mixture was dried and then calcined under the atmosphere at 1150°C for 3 hours.

The mixture was then heat-treated by heating at 1250°C for 9 hours under a nitrogen gas flow containing 12% of hydrogen. The mixture was then washed, dried and sifted so that a phosphor material composed of an aggregate of particles whose D₉₀ is 50 µm or less was produced.

In sample No. 16, M¹ had a molar ratio of strontium carbonate to barium carbonate of 0.15:0.85, and the main crystal and the hetero-phase were (Ba,Sr)₃MgSi₂O₈ and (Ba,Sr)₂SiO₄, respectively. In sample No. 17, M¹ had a molar ratio of calcium carbonate to barium carbonate of 0.15:0.85, and the main crystal and the hetero-phase were (Ba,Ca)₃MgSi₂O₈ and (Ba,Ca)₂SiO₄, respectively.

Sample No. 18 had a molar ratio of zinc acetate to magnesium oxide of 0.15:0.85, and sample No. 19 had a molar ratio of germanium dioxide to silicon dioxide of 0.15:0.85.

The phosphors of sample Nos. 1 to 19 were all prepared without using the so-called flux.

The phosphors prepared by the above process were subjected to X-ray diffraction measurement under the conditions described below. A powder X-ray diffractometer (MAC M18XCE manufactured by Mac Science) with a Cu-Kα X-ray source was used, which was optically adjusted so that the diffraction angle error Δ2θ was reduced to 0.05° or less in the scanning range. The powder X-ray diffraction measurement was performed under conditions such that angle reproducibility could be ensured with a diffraction angle error Δ2θ of 0.05° or less, which was associated with the eccentricity of the sample when the standard silicon 111 peak was used.

Table 2 shows the ratio of the peak intensity of the main crystal corresponding to A/(A+B+C+D), the ratio of the peak intensity of the Ba₂MgSi₂O₇ crystal corresponding to B/(A+B+C+D), the ratio of the peak intensity of the Ba₂SiO₄ crystal corresponding to C/(A+B+C+D), and the ratio of the peak intensity of the BaMgSiO₄ crystal corresponding to D/(A+B+C+D), wherein the main crystal is a Ba₃MgSi₂O₈ crystal containing Eu and Mn as activators, A represents the X-ray diffraction peak intensity of the Ba₃MgSi₂O₈ crystal detected at a 2θ angle of 31.5° to 32°, B represents the X-ray diffraction peak intensity of a Ba₂MgSi₂O₇ crystal detected at a 2θ angle of 27.7° to 28.2°, C represents the X-ray diffraction peak intensity of a Ba₂SiO₄ crystal detected at a 2θ angle of 29.2° to 29.8°, and D represents the X-ray diffraction peak intensity of a BaMgSiO₄ crystal detected at a 2θ angle of 28.0° to 28.4°. In sample Nos. 16 and 17, the peaks slightly shift to the high angle side.

The quantum efficiency of the resulting phosphor was measured using a fluorescence Spectrometer FP-6500 manufactured by JASCO Corporation. In the measurement of the quantum efficiency of the phosphor, the phosphor powder was charged into a dedicated cell and irradiated with 395 nm exciting light when the fluorescence spectrum was measured. The red quantum efficiency was calculated from the result using the quantum efficiency measurement software included with the spectrofluoro-photometer. The result is shown in Table 2. The mark "-" in the peak ratio column of Table 2 means that no peak was visually observed in the result of the X-ray diffraction measurement.

**[Table 1]**

| Sample No. | Chemical Composition | M¹ element | a | a/c | b | b/c | c | x | x/z | y | v/z | z |
|---|---|---|---|---|---|---|---|---|---|---|---|---|
| 1 | M¹₃₋ₐEuₐMg_{1-b}Mn_{b}Si_{c}O₈ | Ba | 0.2 | 0.1 | 0.050 | 0.025 | 2.000 | - | - | - | - | - |
| 2 | M¹₃₋ₐEuₐMg_{1-b}Mn_{b}Si_{c}O₈ | Ba | 0.2 | 0.1 | 0.075 | 0.038 | 2.000 | - | - | - | - | - |
| 3 | M¹₃₋ₐEuₐMg_{1-b}Mn_{b}Si_{c}O₈ | Ba | 0.2 | 0.1 | 0.100 | 0.050 | 2.000 | - | - | - | - | - |
| *4 | M¹₃₋ₐEuₐMg_{1-b}Mn_{b}Si_{c}O₈ | Ba | 0.2 | 0.1 | 0.150 | 0.075 | 2.000 | - | - | - | - | - |
| *5 | M¹₃₋ₐEuₐMg_{1-b}Mn_{b}Si_{c}O₈ | Ba | 0.2 | 0.1 | 0.200 | 0.100 | 2.000 | - | - | - | - | - |
| 6 | Ba_{3-x-y}EuₓMgMn_{y}Si_{z}O₈ | - | - | - | - | - | - | 0.2 | 0.1 | 0.050 | 0.025 | 2.000 |
| 7 | Ba_{3-x-y}EuₓMgMn_{y}Si_{z}O₈ | - | - | - | - | - | - | 0.2 | 0.1 | 0.075 | 0.038 | 2.000 |
| 8 | Ba_{3-x-y}EuₓMgMn_{y}Si_{z}O₈ | - | - | - | - | - | - | 0.2 | 0.1 | 0.100 | 0.050 | 2.000 |
| *9 | Ba_{3-x-y}EuₓMgMn_{y}Si_{z}O₈ | - | - | - | - | - | - | 0.2 | 0.1 | 0.150 | 0.075 | 2.000 |
| *10 | Ba_{3-x-y}EuₓMgMn_{y}Si_{z}O₈ | - | - | - | - | - | - | 0.2 | 0.1 | 0.200 | 0.100 | 2.000 |
| 11 | M¹₃₋ₐEuₐMg_{1-b}Mn_{b}Si_{c}O₈ | Ba | 0.1 | 0.05 | 0.075 | 0.037 | 2.025 | - | - | - | - | - |
| 12 | M¹₃₋ₐEuₐMg_{1-b}Mn_{b}Si_{c}O₈ | Ba | 0.1 | 0.05 | 0.100 | 0.049 | 2.025 | | - | - | - | |
| *13 | M¹₃₋ₐEuₐMg_{1-b}Mn_{b}Si_{c}O₈ | Ba | 0.1 | 0.05 | 0.150 | 0.074 | 2.025 | - | - | - | - | - |
| 14 | Ba_{3-x-y}EuₓMgMn_{y}Si_{z}O₈ | - | - | - | - | - | - | 0.1 | 0.049 | 0.075 | 0.037 | 2.025 |
| 15 | Ba_{3-x-y}EuₓMgMn_{y}Si_{z}O₈ | - | - | - | - | - | - | 0.1 | 0.049 | 0.100 | 0.049 | 2.025 |
| 16 | M¹₃₋ₐEuₐMg_{1-b}Mn_{b}Si_{c}O₈ | Ba,Sr | 0.1 | 0.05 | 0.075 | 0.037 | 2.025 | - | - | - | - | - |
| 17 | M¹₃₋ₐEuₐMg_{1-b}Mn_{b}Si_{c}O₈ | Ba,Ca | 0.1 | 0.05 | 0.075 | 0.037 | 2.025 | - | - | - | - | - |
| *18 | M¹₃₋ₐEuₐ(Mg,Zn)_{1-b}Mn_{b}Si_{c}O₈ | Ba | 0.1 | 0.05 | 0.075 | 0.037 | 2.025 | - | - | - | - | - |
| *19 | M¹₃₋ₐEuₐMg_{1-b}Mn_{b}(Si,Ge)_{c}O₈ | Ba | 0.1 | 0.05 | 0.075 | 0.037 | 2.025 | - | - | - | - | - |

| | | | | | | | | | | | | |
|---|---|---|---|---|---|---|---|---|---|---|---|---|
| Asterisked samples are outside the range of the present invention | | | | | | | | | | | | |

**[Table 2]**

| Sample No. | Peak Ratio of Main Crystal Ba₃MgSi₂O₈ | Peak Ratio of Ba₂MgSi₂O₇ | Peak Ratio of BaMgSiO₄ | Peak Ratio of Ba₂SiO₄ | Quantum Efficiency % |
|---|---|---|---|---|---|
| 1 | 0.9857 | - | - | 0.0143 | 26.9 |
| 2 | 0.9868 | - | - | 0.0132 | 30.59 |
| 3 | 0.9856 | - | - | 0.0144 | 27.49 |
| *4 | 0.9913 | - | - | 0.0087 | 14.37 |
| *5 | 0.9907 | - | - | 0.0093 | 8.76 |
| 6 | 0.9852 | - | 0.0148 | - | 29 |
| 7 | 0.9335 | - | 0.0665 | - | 34.1 |
| 8 | 0.9179 | - | 0.0821 | - | 37 |
| *9 | 0.8533 | - | 0.1467 | - | 24.9 |
| *10 | 0.7926 | - | 0.2074 | - | 16.4 |
| 11 | 0.9715 | - | - | 0.0285 | 32.2 |
| 12 | 0.9753 | - | - | 0.0247 | 31.24 |
| *13 | 0.9885 | - | - | 0.0115 | 24.53 |
| 14 | 0.8814 | 0.0709 | 0.0477 | - | 34.73 |
| 15 | 0.8480 | 0.0571 | 0.0950 | - | 36.73 |
| 16 | 0.9867 | - | - | 0.0133 | 33.73 |
| 17 | 0.9664 | - | - | 0.0336 | 30.3 |
| *18 | 0.8637 | - | - | 0.1363 | 25.2 |
| *19 | 0.7641 | - | - | 0.2359 | 9.43 |

| | | | | | |
|---|---|---|---|---|---|
| Asterisked samples are outside the range of the present invention | | | | | |

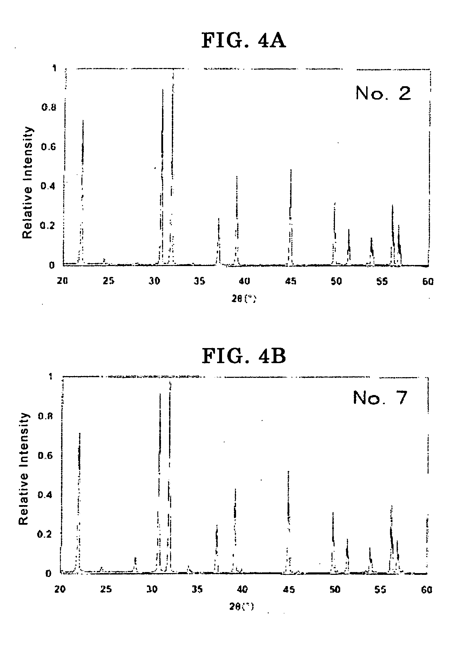

Fig. 4(a) shows the X-ray diffraction pattern of sample No. 2. Fig. 4(b) shows the X-ray diffraction pattern of sample No. 7. In the drawings, the ordinate axis represents the X-ray diffraction intensity, which is a relative value when the maximum value is normalized as 1. The abscissa axis represents the diffraction angle. In No. 7, a peak was observed at a 2θ angle of 28.0° to 28.4°, and the precipitation of a BaMgSiO₄ crystal was demonstrated.

In No. 2, peaks derived from Ba₂MgSi₂O₇, Ba₂SiO₄ and BaMgSiO₄ crystals are very small, and it was demonstrated that the precipitation of these crystals was suppressed and that the desired crystal was accurately precipitated.

It has been found that in samples according to the invention, the precipitation of M¹₂MgSi₂O₇, M¹₂SiO₄ and m¹MgSiO₄ crystals is suppressed so that the generation of green light is suppressed and that the red quantum efficiency is increased.

It has also been found that a quantum efficiency of 35% or more is obtained particularly in samples each with a D/(A+B+C+D) value of 0.04 to 0.26.

### Example 2

Powders of barium carbonate, magnesium oxide, silicon dioxide, europium oxide, and manganese oxide were used. An ammonium chloride powder was used as a flux. The powers were each weighed so that the composition shown in Table 3 could be obtained. The powders were then mixed in a plastic pot. The mixture was dried and then calcined under the atmosphere at 1150°C for 3 hours. The mixture was then heat-treated by heating at 1250°C for 9 hours under a nitrogen gas flow containing 12% of hydrogen so that a phosphor was produced.

The ratio of the peak intensity and the quantum efficiency were determined in the same manner as in Example 1. They are shown in Table 4.

**[Table 3]**

| Sample No. | Chemical Composition | M¹ element | a | a/c | b | b/c | c | x | x/z | y | v/z | z |
|---|---|---|---|---|---|---|---|---|---|---|---|---|
| 20 | M¹₃₋ₐEuₐMg_{1-b}Mn_{b}Si_{c}O₈ | Ba | 0.1 | 0.05 | 0.075 | 0.039 | 1.905 | - | - | - | - | - |
| 21 | M¹₃₋ₐEuₐMg_{1-b}Mn_{b}Si_{c}O₈ | Ba | 0.1 | 0.05 | 0.100 | 0.052 | 1.905 | - | - | - | - | - |
| 22 | Ba_{3-x-y}EuₓMgMn_{y}Si_{z}O₈ | - | - | - | - | - | - | 0.1 | 0.052 | 0.075 | 0.039 | 1.905 |
| 23 | Ba_{3-x-y}EuₓMgMn_{y}Si_{z}O₈ | - | - | - | - | - | - | 0.1 | 0.052 | 0.100 | 0.052 | 1.905 |
| 24 | M¹₃₋ₐEuₐMg_{1-b}Mn_{b}Si_{c}O₈ | Ba | 0.08 | 0.04 | 0.075 | 0.039 | 1.905 | - | - | - | - | - |
| 25 | M¹₃₋ₐEuₐMg_{1-b}Mn_{b}Si_{c}O₈ | Ba | 0.05 | 0.03 | 0.075 | 0.039 | 1.905 | - | - | - | - | - |
| 26 | Ba_{3-x-y}EuₓMgMn_{y}Si_{z}O₈ | - | - | - | - | - | - | 0.08 | 0.042 | 0.075 | 0.039 | 1.905 |
| 27 | Ba_{3-x-y}EuₓMgMn_{y}Si_{z}O₈ | - | - | - | - | - | - | 0.05 | 0.031 | 0.075 | 0.039 | 1.905 |

**[Table 4]**

| Sample No. | Peak Ratio of Main Crystal Ba₃MgSi₂O₈ | Peak Ratio of Ba₂MgSi₂O₇ | Peak Ratio of BaMgSiO₄ | Peak Ratio of Ba₂SiO₄ | Quantum Efficiency % |
|---|---|---|---|---|---|
| 20 | 0.9443 | 0.0191 | 0.0366 | - | 33.9 |
| 21 | 0.9277 | 0.0228 | 0.0494 | - | 34.8 |
| 22 | 0.9446 | - | 0.0554 | - | 34.8 |
| 23 | 0.9145 | - | 0.0855 | - | 35.5 |
| 24 | 0.9720 | - | 0.0280 | - | 32.6 |
| 25 | 0.9812 | - | 0.0188 | - | 30.7 |
| 26 | 0.9636 | 0.0113 | 0.0251 | - | 32 |
| 27 | 0.9576 | 0.0208 | 0.0216 | - | 30.4 |

Tables 3 and 4 show that in samples according to the invention, the precipitation of Ba₂MgSi₂O₇, Ba₂SiO₄ and BaMgSiO₄ crystals is suppressed so that the generation of green light is suppressed and that the red quantum efficiency is increased. It is also apparent that a quantum efficiency of 35% or more is obtained particularly in samples each with a D/(A+B+C+D) value of 0.04 to 0.26.

### Example 3

Powders of barium carbonate, magnesium oxide, strontium carbonate, silicon dioxide, europium oxide, and manganese oxide were mixed so that the a, b and c values shown in Table 5 could be obtained for the compositional formula M¹₃₋ₐEuₐMg_{1-b}Mn_{b}Si_{c}O₈. A predetermined amount of ammonium chloride was added as a flux. The materials were mixed in a plastic pot. The mixture was dried and then calcined under the atmosphere at the temperature shown in Table 5 for 3 hours. The mixture was then heat-treated by heating at the temperature shown in Table 5 for 9 hours under a nitrogen gas flow containing 12% of hydrogen (a reducing atmosphere) so that a phosphor according to the invention was prepared. In sample No. 4, a combination of Ba and Sr was used as M¹, the main crystal and the second phase were (Ba,Sr)₃MgSi₂O₈ and (Ba,Sr)MgSiO₄, respectively.

Fig. 2 shows a scanning electron microscopy (SEM) photograph (at a magnification of 1000x) of a phosphor according to the invention. In the sample within the scope of the invention, the second phase M¹MgSiO₄ crystal grains were found in the M¹₃MgSi₂O₈ crystal grains.

The quantum efficiency of the resulting phosphor was measured using a spectrofluoro-photometer FP-6500 manufactured by JASCO Corporation. In the measurement of the quantum efficiency of the phosphor, the phosphor powder was charged into a dedicated cell and irradiated with 395 nm exciting light when the fluorescence spectrum was measured. The red quantum efficiency was calculated from the result using the quantum efficiency measurement software included with the spectrofluoro-photometer. The result is shown in Table 6.

The X-ray diffraction measurement of the phosphor was performed in the same manner as described above.

B/(A+B+C+D), C/(A+B+C+D) and D/(A+B+C+D) were calculated from the result and are shown in Table 4, wherein A represents the X-ray diffraction peak intensity of the M¹₃MgSi₂O₈ crystal detected at a 2θ angle of about 31.5° to about 32°, B represents the X-ray diffraction peak intensity of an M¹₂MgSi₂O₇ crystal detected at a 2θ angle of 27.7° to 28.2°, C represents the X-ray diffraction peak intensity of an M¹₂SiO₄ crystal detected at a 2θ angle of 29.2° to 29.8°, and D represents the X-ray diffraction peak intensity of an M¹MgSiO₄ crystal detected at a 2θ angle of 28.0° to 28.4°. In sample No. 4, the positions of the detected peaks slightly shift to the high angle side from those in the case that M¹ is Ba.

Samples within the scope of the invention are each composed substantially of the main Ba₃MgSi₂O₈ crystal and the second phase BaMgSiO₄ crystal and substantially free of M¹₂MgSi₂O₇ and M¹₂SiO₄ crystals.

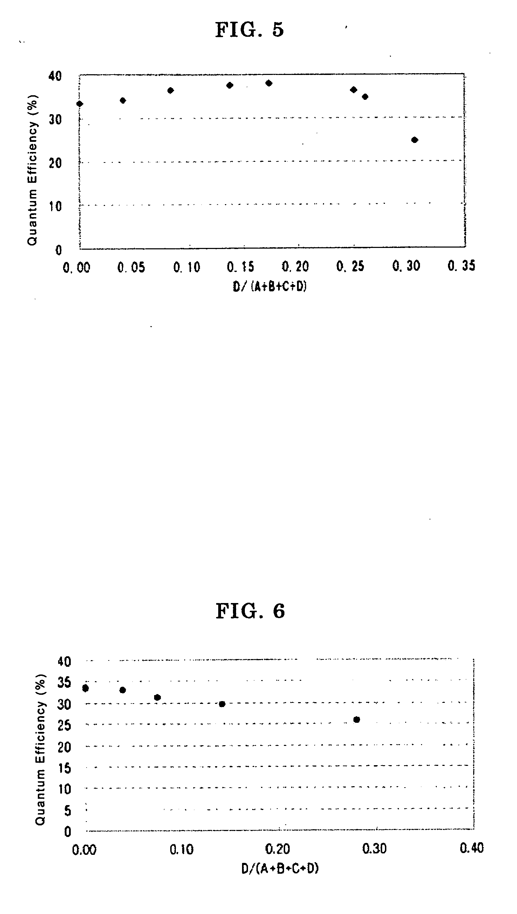

Fig 5 shows the relationship between the peak intensity ratio D/(A+B+C+D) and the red quantum efficiency in the samples.

**[Table 5]**

| Sample No. | Chemical Composition | M¹ element | a | a/c | b | b/c | c | calcining temperature (°C) | heat-treating temperature in the reducing atmosphere (°C) |
|---|---|---|---|---|---|---|---|---|---|
| 1 | M¹₃₋ₐEuₐMg_{1-b}Mn_{b}Si_{c}O₈ | Ba | 0.075 | 0.039 | 0.075 | 0.039 | 1.905 | 1150 | 1250 |
| 2 | M¹₃₋ₐEuₐMg_{1-b}Mn_{b}Si_{c}O₈ | Ba | 0.225 | 0.118 | 0.075 | 0.039 | 1.905 | 1150 | 1250 |
| 3 | M¹₃₋ₐEuₐMg_{1-b}Mn_{b}Si_{c}O₈ | Ba | 0.264 | 0.139 | 0.075 | 0.039 | 1.905 | 1150 | 1250 |
| 4 | M¹₃₋ₐEuₐMg_{1-b}Mn_{b}Si_{c}O₈ | (Ba_{0.75}Sr_{0.25}) | 0.2 | 0.105 | 0.100 | 0.052 | 1.905 | 1150 | 1250 |
| 5 | M¹₃₋ₐEuₐMg_{1-b}Mn_{b}Si_{c}O₈ | Ba | 0.2 | 0.105 | 0.132 | 0.069 | 1.905 | 1150 | 1250 |
| 6 | M¹₃₋ₐEuₐMg_{1-b}Mn_{b}Si_{c}O₈ | Ba | 0.075 | 0.039 | 0.075 | 0.039 | 1.905 | 900 | 1150 |
| 7 | M¹₃₋ₐEuₐMg_{1-b}Mn_{b}Si_{c}O₈ | Ba | 0.2 | 0.105 | 0.075 | 0.039 | 1.905 | 950 | 1150 |
| 8 | M¹₃₋ₐEuₐMg_{1-b}Mn_{b}Si_{c}O₈ | Ba | 0.2 | 0.105 | 0.075 | 0.039 | 1.905 | 950 | 1200 |
| 9 | M¹₃₋ₐEuₐMg_{1-b}Mn_{b}Si_{c}O₈ | Ba | 0.2 | 0.105 | 0.075 | 0.039 | 1.905 | 950 | 1250 |
| 10 | M¹₃₋ₐEuₐMg_{1-b}Mn_{b}Si_{c}O₈ | Ba | 0.2 | 0.105 | 0.075 | 0.039 | 1.905 | 1050 | 1200 |
| 11 | M¹₃₋ₐEuₐMg_{1-b}Mn_{b}Si_{c}O₈ | Ba | 0.2 | 0.105 | 0.075 | 0.039 | 1.905 | 1150 | 1200 |
| 12 | M¹₃₋ₐEuₐMg_{1-b}Mn_{b}Si_{c}O₈ | Ba | 0.2 | 0.105 | 0.075 | 0.039 | 1.905 | 1250 | 1250 |
| *13 | M¹₃₋ₐEuₐMg_{1-b}Mn_{b}Si_{c}O₈ | Ba | 0.2 | 0.105 | 0.075 | 0.039 | 1.905 | 1250 | 1300 |

| | | | | | | | | | |
|---|---|---|---|---|---|---|---|---|---|
| Asterisked samples are outside the range of the present invention | | | | | | | | | |

**[Table 6]**

| Sample No. | Peak Ratio of Main Crystal Ba₃MgSi₂O₈ | Peak Ratio of Ba₂MgSi₂O₇ | Peak Ratio of BaMgSiO₄ | Peak Ratio of Ba₂SiO₄ | Quantum Efficiency % |
|---|---|---|---|---|---|
| 1 | 0.949 | - | 0.051 | - | 34.20 |
| 2 | 0.944 | - | 0.056 | - | 36.10 |
| 3 | 0.941 | - | 0.059 | - | 32.50 |
| 4 | 0.920 | - | 0.080 | - | 34.60 |
| 5 | 0.896 | - | 0.104 | - | 35.60 |
| 6 | 1 | - | - | - | 33.40 |
| 7 | 0.960 | - | 0.040 | - | 34.20 |
| 8 | 0.918 | - | 0.082 | - | 36.50 |
| 9 | 0.862 | - | 0.138 | - | 37.60 |
| 10 | 0.827 | - | 0.173 | - | 38.00 |
| 11 | 0.750 | - | 0.250 | - | 36.50 |
| 12 | 0.740 | - | 0.260 | - | 34.70 |
| *13 | 0.695 | - | 0.305 | - | 24.70 |

| | | | | | |
|---|---|---|---|---|---|
| Asterisked samples are outside the range of the present invention | | | | | |

It is apparent from Tables 5 and 6 and Fig. 5 that the phosphors within the scope of the invention each have a D/(A+B+C+D) value of 0.4 to 0.26, show efficient energy transfer from the BaMgSiO₄ crystal and have high red quantum efficiency.

In contrast, the phosphor with a relative value of X-ray diffraction peak intensity outside the scope of the invention (sample No. 13) contains a large amount of the precipitated BaMgSiO₄ crystal and is found to have low red quantum efficiency.

The inventors have made experiments on the quantum efficiency in the case that the Ba₃MgSi₂O₈ and BaMgSiO₄ crystal grains exist separately and in the case that the BaMgSiO₄ crystal grains exist in the Ba₃MgSi₂O₈ crystal grains.

Specifically, a BaMgSiO₄ crystal powder was added to a Ba₃MgSi₂O₈ powder, and the quantum efficiency of the mixture was determined. The result is shown in the graph of Fig. 6. Fig. 6 shows that an increase in the amount of the addition of the BaMgSiO₄ crystal powder to the Ba₃MgSi₂O₈ powder results in a reduction in quantum efficiency. It is therefore found that the presence of the BaMgSiO₄ crystal grains in the Ba₃MgSi₂O₈ crystal grains allows an improvement in quantum efficiency.

### BRIEF DESCRIPTION OF DRAWINGS

Fig. 1 is a graph showing the result of powder X-ray diffraction measurement of phosphors;
Fig. 2 is an SEM photograph showing a structure containing M¹MgSiO₄ crystal grains present in M¹₃MgSi₂O₈ crystal grains;
Fig. 3 is a schematic cross-sectional view showing the structure of a illumination device;
Fig. 4(a) is an X-ray diffraction diagram of sample No. 2 in Table 1;
Fig. 4(b) is an X-ray diffraction diagram of sample No. 7 in Table 1;
Fig. 5 is a graph showing the relationship between the peak intensity ratio D/(A+B+C+D) and the red quantum efficiency; and
Fig. 6 is a graph showing quantum efficiencies obtained with an increase in the amount of the addition of a BaMgSiO₄ crystal powder to a Ba₃MgSi₂O₈ crystal powder.

## Claims

1. A phosphor, comprising:
M¹, Eu, Mg, Mn, and Si as essential components, wherein M¹ represents Ba, a combination of Ba and Sr or a combination of Ba and Ca, the molar ratio of Eu to Si is 0.14 or less, and the molar ratio of Mn to Si is 0.07 or less; and an M¹₃MgSi₂O₈ crystal as a main crystal, wherein the m¹₃MgSi₂O₈ crystal contains Eu and Mn, and B/ (A+B+C+D) is 0.1 or less, C/(A+B+C+D) is 0.1 or less, and D/(A+B+C+D) is 0.26 or less, wherein A represents the X-ray diffraction peak intensity of the M¹₃MgSi₂O₈ crystal detected at a 2θ angle of 31.5° to 33°, B represents the X-ray diffraction peak intensity of an M¹₂MgSi₂O₇ crystal detected at a 2θ angle of 27.7° to 29.2°, C represents the X-ray diffraction peak intensity of an M¹₂SiO₄ crystal detected at a 2θ angle of 29.2° to 30.8°, and D represents the X-ray diffraction peak intensity of an M¹MgSiO₄ crystal detected at a 2θ angle of 28.0° to 29.4°.

2. The phosphor according to claim 1, wherein D/(A+B+C+D) is 0.04 or more.

3. The phosphor according to claim 1 or 2, wherein it has a chemical composition represented by M¹₃₋ₐEuₐMg_{1-b}Mn_{b}Si_{c}O₈, wherein a is a value satisfying 0<a≤0.264, b is a value satisfying 0<b≤0.132, and c is a value satisfying 1.905≤c≤2.025.

4. The phosphor according to any one of claims 1 to 3, wherein M¹MgSiO₄ crystal grains exist in the M¹₃MgSi₂O₈ crystal grains.

5. A process for producing a phosphor, comprising heat-treating, in a reducing atmosphere, a material powder having a chemical composition represented by M¹₃₋ₐEuₐMg_{1-b}Mn_{b}Si_{c}O₈, wherein a is a value satisfying 0<a≤0.264, b is a value satisfying 0<b≤0.132, and c is a value satisfying 1.905≤c≤2.025.

6. A wavelength converter configured to change a wavelength of light emitted from a light source and outputting light containing light with the chanced wavelength, comprising the phosphor of any one of claims 1 to 4 dispersed in a transparent matrix.

7. An illumination device, comprising:
a base member comprising a mounting part configured to mount a light-emitting element on a surface thereof, and an electrical wiring;
a light-emitting element that is placed on the mounting part and electrically connected to the electrical wiring; and
the wavelength converter of claim 6 operable to change a wavelength of light emitted from the light-emitting element.

8. A luminaire, comprising a plurality of the illumination devices of claim 7.
